(19) Europäisches Patentamt
European Patent Office
Office européen des brevets

(11) **EP 4 663 786 A1**

(12) **EUROPEAN PATENT APPLICATION**

(43) Date of publication:
**17.12.2025   Bulletin 2025/51**

(21) Application number: **24461588.6**

(22) Date of filing: **14.06.2024**

(51) International Patent Classification (IPC):
*C22B 3/26* (2006.01)      *C01D 3/12* (2006.01)
*C01G 21/16* (2006.01)    *C22B 7/00* (2006.01)
*H10K 30/50* (2023.01)    *C22B 13/00* (2006.01)
*H10K 85/00* (2023.01)    *C22B 3/00* (2006.01)

(52) Cooperative Patent Classification (CPC):
**C22B 7/006; C01D 3/12; C01G 21/16; C22B 3/262; C22B 13/045; H10K 85/50**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Saule S.A.**
**54-427 Wroclaw (PL)**

(72) Inventors:
• **OZ, Senel**
**51469 Bergisch Gladbach (DE)**
• **PRZYPIS, Lukasz**
**44-186 Gieraltowice (PL)**
• **ASKIN, Asmin**
**12489 Berlin (PL)**

(74) Representative: **Kancelaria Eupatent.pl Sp. z o.o.**
**ul. Jana Kilinskiego 193 lok. 2.13**
**93-106 Lodz (PL)**

(54) **A METHOD FOR RECOVERING A COMPONENT FROM A PEROVSKITE STRUCTURE**

(57)     A method for recovering at least one component from a perovskite-containing structure comprising a perovskite material ABX$_3$, the method comprising the steps of: preparing a functional solution, treating the perovskite-containing structure with the functional solution to dissolve the perovskite material and to obtain a reaction mixture, adding a complementary solvent to the reaction mixture, obtaining a precipitate containing the component to be recovered, separating the component to be recovered from the reaction mixture, collecting the component, characterized in that the functional solution comprises a protic ionic liquid.

Fig. 1

EP 4 663 786 A1

# EP 4 663 786 A1

**Description**

INFORMATION ON EU FUNDING

The project leading to this application has received funding from the European Union's Horizon Europe research and innovation programme under grant agreement No 101075605.

TECHNICAL FIELD

The present disclosure belongs to the field of recycling technologies. More specifically, it relates to methods for recovering valuable materials from perovskite structures. This invention focuses on enhancing the efficiency and environmental sustainability of recovery processes as well as purity of extracted materials.

BACKGROUND

In recent years, perovskite materials have gained significant attention due to their exceptional characteristics, especially in the field of perovskite photovoltaics. Perovskite solar devices offer high power conversion efficiencies, tunable optoelectronic properties and excellent performance under diverse conditions, including outdoor and indoor environments. The possibility of fabricating highly-efficient, flexible perovskite solar devices using low-temperature, solution-based techniques and earth-abundant materials have provoked serious interest. Perovskite based photovoltaics provide a cost-effective and highly-versatile alternative to known photovoltaic technologies across various fields, including building-integrated photovoltaics, renewable energy infrastructure, portable electronics and IoT devices.

However, despite many advantages and the remarkable progress of the perovskite photovoltaic technology over the past years, it faces challenges connected with the presence of toxic elements, like lead. Lead toxicity introduces certain concerns for this technology related to environmental impact, health risks and regulatory restrictions on hazardous materials. It is widely expected, that the perovskite technology will soon become a leading player in solar energy production, which will inevitably lead to an increase in generated waste volume. Therefore, the abovementioned concerns need serious consideration before this technology gains deserved market acceptance and becomes widely applicable on the market.

Various attempts are being made to address the problem of lead toxicity of perovskite technology, including research and development of lead-free alternatives, device stability improvement to reduce degradation and leaching of lead and end-of-life management to handle proper disposal procedures. One of the promising ideas to address this problem is to look for efficient recycling methods for safe recovery of lead from worn perovskite devices.

A publication of the US patent application US18/522,428 describes a method for recycling lead iodide from a waste perovskite device by dissolving the waste device in an iodide solution and diluting the supernatant to form lead iodide crystals. However, these crystals contain impurities, which is why an additional purification step involving acid treatment and washing is imposed in order to obtain recycled lead iodide. This multi-step washing process adds complexity, time and potential costs to the process and may present concerns related to scalability and practicality for large-scale recycling operations. Additionally, the chemicals used in the washing process, including isopropanol, ether and acids, such as glacial acetic acid or formic acid, require safety precautions in handling and disposal to minimize health risks and environmental impact.

A publication of the Taiwanese patent TWI810867 B describes a multistep method for recovering valuable materials from a perovskite solar cell, including lead-containing materials, such as lead halides: $PbI_2$ and $PbBr_2$. The method involves dissolving perovskite material in an organic solvent to obtain a mixture of metal cations and halogen anions in an organic solvent, oxidizing and heating the mixture to form halogen molecules and solid residues, rinsing the residues with deionized water to form a solid phase and a liquid phase, where the solid phase is mixed with the halogen molecules to obtain a first lead halide, and the liquid phase is subjected to extraction and concentration steps to obtain a second metal halide. This method, however presents certain drawbacks. It is a multi-step, complex process, potentially posing challenges for scalability, making it difficult to apply on large-scale. Moreover, this method involves using *N,N*-Dimethylformamide (DMF) as the organic solvent. Use of DMF introduces some disadvantages related to health risks and regulatory restrictions, due to its high toxicity and a relatively high cost. DMF may also be a concern related to environmental impact, since it is not easily biodegradable.

A publication of the international patent application PCT/FI2018/050983 discloses a method for recovering perovskite components, including organic precursors and lead iodide from a carbon based perovskite solar cell and reusing the mixture to fabricate a fresh perovskite precursor ink. This method includes the steps of dissolving the perovskite layer in a polar aprotic solvent, obtaining a solution containing the solvent and perovskite components and separating the solvent from the perovskite components, which may be suitable for a reuse. Additionally, the method according to this publication teaches a method for recovery of $PbI_2$ from the perovskite solar cell, which includes the step of immersing the lead containing electrode in a polar aprotic solvent, heating the obtained solution and separating the $PbI_2$ from the solvent by vacuum distillation or rotary evaporation. The described processes present drawbacks in that they use toxic polar aprotic solvents, such as gamma-butyro lactone (GBL) *N,N*-Dimethylformamide (DMF), Acetone, DMSO or Acetonitrile. Using any of these solvents is undesirable due to health-related risks and difficulties in mass-production. Additionally the disclosed process requires the step of heating, which makes the process more complex and costly.

The above-mentioned methods have made some contributions to the field of recovering perovskite components, especially lead-containing ones. However, they suffer from certain limitations preventing them from being suitable for large scale industrial applications. These challenges lie in complexity of currently known solutions, as well as presence of toxic solvents and impracticality.

SUMMARY OF THE INVENTION

Therefore, it would be desirable to address at least some of the limitations of known solutions, which are preventing perovskite photovoltaic technology from unlocking its full potential and being effectively integrated into mainstream solar energy conversion systems. In particular, there is a need to develop an improved method for recovering perovskite components from perovskite structures that enables simpler, more efficient and/or more environmentally friendly recovery process.

The process according to the present invention is aimed to retrieve highly pure perovskite components suitable for future reuse, without the need of using elevated temperatures, complicated, multistep treatments and toxic solvents, which makes it suitable for large scale industrial operations. The significance of this invention lies in its potential to revolutionize the field of perovskite recycling by overcoming at least some of the limitations of existing solutions, which enables to make a next step towards commercial applications of perovskite solar cells, contributing to the global transition towards sustainable energy sources.

In one aspect, the invention relates to a method for recovering at least one component from a perovskite-containing structure comprising a perovskite material of a formula $ABX_3$. The method comprises the steps of: (a) preparing a functional solution, (b) treating the perovskite-containing structure with the functional solution to dissolve the perovskite material and to obtain a reaction mixture, (c) adding a complementary solvent to the reaction mixture, (d) obtaining a precipitate containing the component to be recovered, (e) separating the component to be recovered from the reaction mixture and (f) collecting the component. The functional solution comprises a protic ionic liquid.

The method comprising the steps according to the present disclosure allows to effectively recover the component from the perovskite-containing structure. The perovskite-containing structure shall be understood as a structure comprising the perovskite material. The perovskite material is the perovskite material of a general formula $ABX_3$, and will be referred to as the perovskite material. The perovskite-containing structure will be referred to herein also as the perovskite structure. The amount of the perovskite material within the perovskite structure is not particularly limited. In one aspect of the present invention, the perovskite structure mostly comprises the perovskite material. As such, preferably, the perovskite structure is in form of a pellet comprising the perovskite material, in form of a powder comprising the perovskite material, in form of a layer comprising the perovskite material, which layer forms part of an optoelectronic device, such as a photovoltaic device, or the like. In another aspect of the present invention, the perovskite structure is an optoelectronic device, such as a photovoltaic device, which comprises a certain amount of the perovskite material along with other elements, such as, but not limited to charge transporting layers, passivation layers, electrodes, substrates, encapsulation systems, and the like. The photovoltaic device shall be understood as a photovoltaic cell or a photovoltaic module comprising the photovoltaic cells. The component recovered according to this method is of high purity, which at least limits, or even does not impose, a necessity for further purification steps before the recovered component is suitable for reuse. This provides a significant technological advantage, since the complexity of the process and the overall process cost is reduced. Additionally, the method of the present disclosure enables efficient recovery of the component of high purity in low temperature, such as room temperature. This provides lower energy consumption and better process control, since no elevated temperatures need to be reached, maintained and controlled. The method according to the present disclosure using the functional solution comprising the protic ionic liquid allows at least to limit, or even avoid, the presence of toxic solvents, which are commonly used in currently known component recovery processes. Toxic solvents are highly undesirable for several reasons, such as negative environmental impact, health risks, safety concerns in handling and storage and economic impact, due to necessity of complying with strict regulations and significant disposal costs. Additionally, the protic ionic liquids possess low vapor pressure, which makes them safer to handle as they are less likely to produce flammable or hazardous vapors. The functional solution comprising the protic ionic liquid allows to effectively dissolve the perovskite material of the perovskite structure. The step of adding the complementary solvent to the reaction mixture comprising the functional solution and the dissolved perovskite material allows control over the process of obtaining the precipitate containing the component to be recovered. The complementary solvent may be added in an amount necessary for recovering a desired component, according to the needs, which makes the process more universal compared to the state of the art and allows to have more control over the recovery process, as different components may be recovered.

Preferably, the perovskite material is of a general formula $ABX_3$, wherein A is a cation selected from: an alkylammonium cation, such as methylammonium (MA), a formamidinium cation (FA), a metal cation, such as Cs, or a cation comprising any mixture thereof, B is a metal selected from: Pb, Sn, or a mixture of Pb and Sn, and X is a halide anion selected from the group consisting of $I^-$, $Br^-$ or $Cl^-$, $F^-$ or a mixture thereof. The method according to the present disclosure is effective for perovskite structures comprising $ABX_3$ perovskites. Said $ABX_3$ perovskites are highly desirable and widely used in the field of photovoltaics, LEDs, lasers and photodetectors, due to their excellent optoelectronic properties. The method according to the present disclosure allows to efficiently recover the component from $ABX_3$ perovskites. The non limiting examples of the $ABX_3$ perovskite materials suitable for efficient component recovery according to the presented method are: $MAPbI_3$, $FAPbI_3$, $CsPbI_3$, $MAPbBr_3$, $FAPbBr_3$, $CsPbBr_3$, $MAPbCl_3$, $FAPbCl_3$, $CsPbCl_3$ or the like. Preferably, the perovskite structure, according to the present disclosure comprises the perovskite material having 0D, 1D, 2D, 3D structures or any combinations thereof. The method according to the present disclosure provides the same effect for perovskite material having 0D, 1D, 2D, 3D structures or any combinations thereof as it does for 3D ($ABX_3$) perovskites, as described above.

Preferably, the perovskite material is a mono or mixed A-site cation perovskite, a mixed metal perovskite, a mixed halide anion perovskite and/or any combination thereof. The method according to the present disclosure is effective for perovskite structures comprising perovskite materials being mixed A-site cation perovskites, such as, but not limited to $(FA)_x(MA)_{1-x}PbI_3$, $(FA)_x(Cs)_y(MA)_{1-x-y}PbI_3$. Mixed A-site cation perovskites provide improved stability, enhanced photovoltaic performance and may provide reduced amount of defects. The presented method allows to efficiently recover components from mixed metal perovskites, such as, but not limited to $MAPb_{1-x}Sn_xI_3$, $FAPb_{1-x}Sn_xI_3$. Mixed metal perovskites may offer tailored electronic properties due to mixing of different metals and reduced toxicity, by partially replacing lead with less toxic metals, such as Sn. The method according to the present disclosure is suitable for efficient component recovery from mixed halide anion perovskites, such as, but not limited to $MAPb(I_{1-x}Br_x)_3$, $FAPb(I_{1-x}Br_x)_3$, $CsPb(I_{1-x}Br_x)_3$. Mixed-halide perovskites allow precise tuning of the perovskite's bandgap and development of devices with tailored properties for specific applications. The presented method is suitable for successful recovery of components from perovskite structures being any combinations of abovementioned mixed A-site cation, mixed metal and mixed halide anion perovskites, such as, but not limited to $(FA)_x(MA)_{1-x}Pb(I_{1-y}Br_y)_3$, $(FA)_x(Cs)_y(MA)_{1-x-y}Pb(I_{1-z}Br_z)_3$, $(FA)_x(MA)_{1-x}Pb_{1-y}Sn_y(I_{1-z}Br_z)_3$. Using such mixed perovskites may provide synergistic effects of the effects mentioned above enhancing the overall material properties, leading to superior performance in terms of stability, efficiency and tunability which offers high flexibility in designing perovskites with specific desired properties for a wide range of applications. The presented method for recovering components from perovskite structures provides an efficient and versatile alternative, since it is not limited to particular perovskite materials. It allows to effectively recover the component of high purity from said perovskite materials, with reduced or eliminated necessity of additional purification steps and with reduced or without the need of using elevated temperatures or toxic solvents.

Preferably, each of steps (a)-(f) is carried out at a temperature of less than 80°C, preferably at or close to a room temperature.

The disclosed method enables effective perovskite material dissolution at a temperature of less than 80°C. It also enables efficient formation of the precipitate containing the component to be recovered at a temperature of less than 80°C. The functional solution comprising the protic ionic liquid enables effective perovskite material dissolution within such a temperature range. The step of adding the complementary solvent within the disclosed temperature range facilitates the precipitate formation and allows to obtain the recovered component of high purity. Preferably, the temperature is less than 60°C, less than 50°C, less than 40°C or less than 30°C. Such temperature ranges allow to obtain the abovementioned effects and require less heating. Preferably, the temperature is close to or equal to a room temperature. Such a temperature range is particularly beneficial, since not only it enables effective dissolution of the perovskite material and efficient formation of the component to be recovered, where the recovered component is of high purity, but also due to energy efficiency, cost saving and scalability perspective, as well as easier process control and safety, since no elevated temperatures are needed. These benefits make the disclosed process carried out at said temperature range, such as close to or equal to a room temperature highly desirable in both industrial and laboratory settings.

Preferably, the method comprises step (g) of recovering the functional solution for reuse. Such step (g) comprises extracting from the functional solution the complementary solvent contained therein after step (f) of collecting the component. The extracting and removing step may be any of centrifugation, distillation, residue adsorption, evaporation and the like. After this step is performed, the functional solution becomes particularly suitable for reuse, since it will contain reduced amount of the complementary solvent or will contain no complementary solvent at all. This provides a great benefit when it comes to process sustainability and economic aspect, since there is no need to prepare the new functional solution before each recovery process and the generated waste is largely reduced. Preferably, step (g) is carried out at a temperature of less than 80°C, such as less than 60°C, less than 40°C or close to or equal to a room temperature. Preferably, step (g) of recovering the functional solution for reuse is performed at similar temperature range as the preceding steps (a)-(f), so that no specific environment has to be created for this specific step. The functional solution after steps (a)-(g) are performed is suitable to be reused in a new recovery process according to the present disclosure or may be reused in a different according to the needs. Preferably, step (g) comprises the step of removing other residues from the functional solution, such as hole transporting material. These residues can be removed by the known methods, selected accordingly to the type of residue to be removed. The step of extracting and removing the other residues allows to clean the functional solution from unnecessary ingredients introduced during the process.

Preferably, the complementary solvent is added to the reaction mixture in a volume ratio of the complementary solvent to the functional solution between 0.1:1 and 40: 1.

The complementary solvent provided within given volume ratio provides the desired effect of facilitating the formation of the precipitate containing the component to be recovered. The volume ratio within said range allows to selectively form the precipitate containing desired component to be recovered. The component suitable for being recovered according to the presented method and by presence of the complementary solvent with abovementioned volume ratio is any of $ABX_3$ and $BX_2$. Recovery of valuable components from perovskite structures promotes circular economy, sustainability and cost effectiveness. The components recovered according to the present disclosure are of high purity and may be reused to provide new practical applications, which supports sustainable practices, such as sustainable resource management and waste reduction. The presented method is not limited to recovering a single component from the perovskite structure, which increases versatility and provides a more universal approach compared to the known solutions. Which of the components selected from $ABX_3$ and $BX_2$ is recovered from the perovskite structure depends on, among others, the volume ratio of the complementary solvent in the functional solution. A lower volume ratio, such as 0.1:1 or more allows to obtain $ABX_3$ as the recovered component. Said lower volume ratio may be selected from the range 0.1:1 to 1:1 or 0.5:1 to 1:1. Preferably, the volume ratio of the complementary solvent to the functional solution is selected so as to obtain the $ABX_3$ as the component. $ABX_3$ recovered according to the presented method is of high purity and requires limited purification or does not require any additional purification step at all, which is why it may be reused to form a new perovskite structure, for example a layer of perovskite photoactive material in a solar cell. A higher volume ratio, such as 40:1 or less allows to obtain $BX_2$ as the recovered component, including $PbX_2$, such as, but not limited to $PbI_2$ or $PbBr_2$. Said higher volume ratio may be selected from the range 2:1 to 40:1, 2:1 to 20:1, 2:1 to 17.5:1, 2:1 to 7:1 or so. Preferably, the higher volume ratio of the complementary solvent to the functional solution is selected so as to obtain the $PbX_2$ as the component. Similarly to $ABX_3$, the components in form of $PbI_2$ or $PbBr_2$ recovered from perovskite structures according to the presented method are of high purity. Efficient recovery of lead from perovskite structures is highly desired, mostly due to environmental, regulatory and safety concerns. It leads to decrease of toxic waste, therefore reducing the risk of soil contamination and other negative environmental consequences. It also helps in compliance with harsh regulations related to hazardous materials, and provides safety improvements, by minimizing exposure of workers to toxic substances during manufacturing and disposal processes and therefore making the perovskite technology more practicable. The method according to the present disclosure allows to recover the lead-containing component of high purity, with little or no contamination, such that additional purification steps are reduced or even not required and the recovered component components in form of $PbI_2$ or $PbBr_2$ may be reused, e.g. as a new perovskite-forming precursor.

Preferably, the functional solution comprises the protic ionic liquid of a general formula:

$$M^+N^-$$

wherein:

M$^+$ represents a cation selected from the group of $C_1$-$C_{20}$ alkyl ammonium cations,
N$^-$ represents at least one carboxylate anion, preferably selected from the group of $C_1$-$C_{20}$ carboxylate anions.

The protic ionic liquid according to this formula provides good dissolving properties, which makes it particularly beneficial in the method according to the present disclosure. It allows to rapidly dissolve the perovskite material, wherein the perovskite material is not particularly limited and may be selected from 0D, 1D, 2D, 3D structures or any combinations thereof. The protic ionic liquid according to the abovementioned formula is suitable for effective dissolution of $ABX_3$ perovskites, such as, but not limited to $MAPbI_3$, $FAPbI_3$, $CsPbI_3$, $MAPbBr_3$, $FAPbBr_3$, $CsPbBr_3$, $MAPbCl_3$, $FAPbCl_3$, $CsPbCl_3$ or the like. The protic ionic liquid according to the abovementioned formula is suitable for effective dissolution of mixed A-site cation perovskites, which were described more in details above. Also, the protic ionic liquid according to the abovementioned formula is suitable for effective dissolution of mixed metal perovskites, which were also described above. Also, the protic ionic liquid according to the abovementioned formula is suitable for effective dissolution of mixed halide anion perovskites, such as the ones described above. Additionally, the protic ionic liquid according to the abovementioned formula is suitable for effective dissolution of combinations of mixed A-site cation, mixed metal and/or mixed halide anion perovskites as described above. The protic ionic liquid according to the abovementioned formula allows at least to limit, or even avoid, the presence of toxic solvents, which are commonly used in currently known component recovery processes. Additionally, the protic ionic liquids according to this formula possess low vapor pressure, which makes them safer to handle as they are less likely to produce flammable or hazardous vapors. Preferably, the functional solution comprises a single protic ionic liquid. Alternatively, the functional solution may comprise a combination of at least two protic ionic liquids.

Preferably, the functional solution comprises the protic ionic liquid selected from the group of MAF, MAAc, MAP, MABur, MAVal, MAC$_6$, EAF, EAAc, EAP, EABur, EAVal, EAC$_6$, PrAF, PrAc, PrAP, PrBur, PrVal, PrC$_6$, BuF, BuAc, BuP, BuBur, BuVal, BuC$_6$,PenF, PenAc, PenP, PenBur, PenVal, PenC$_6$, HexF, HexAc, HexP, HexBur, HexVal, HexC$_6$.

The protic ionic liquids selected from this group are particularly effective in the presented method. They provides good dissolving properties making them suitable for dissolving perovskite materials according to this disclosure. Additionally, they are easy to obtain using basic laboratory equipment, making their use more practical. The protic ionic liquids selected from the abovementioned list exhibit high reusability, which makes them applicable in scalable processes and provides sustainability, since they may be reused in new recovery processes. Moreover, they are low toxic or at least less toxic than the solvents conventionally used in recycling processes and they are pH neutral, which fact addresses environmental, safety, regulatory and health-related concerns. Additionally, the protic ionic liquids according to this formula possess low vapor pressure, which makes them safer to handle as they are less likely to produce flammable or hazardous vapors.

Preferably, the complementary solvent is selected from the group consisting of water, ethanol, propanol, isopropanol, butanol, γ-butyrolactone, valerolactone, acetonitrile and ethyl lactate. The complementary solvents selected from the abovementioned list provide the desired effect of facilitating the precipitate formation. Also, they are low toxic and they are classified as green solvents, which address the environmental and safety concerns. Preferably, the complementary solvent is water. Water is especially suitable to efficiently work as the complementary solvent, since it facilitates the formation of the precipitate containing the component to be recovered. Facilitating the precipitate formation step makes the process more efficient and helps in quicker component separation from the reaction mixture and final recovery. Waterworks particularly well with the functional solution comprising the protic ionic liquid according to this disclosure. The combination of water and the functional solution comprising the protic ionic liquid allows to efficiently form and collect the precipitate containing the component to be recovered, where the component is of high purity. Also, water is considered a green solvent, which is highly beneficial in industrial applications, making the process more eco-friendly, sustainable and straight-forward, since no complex solvent systems or toxic solvents need to be used. Water used as the complementary solvent according to the present disclosure enables efficient formation of the precipitate containing the component to be recovered and overcomes the challenges related to presence of toxic solvents. Water, as the complementary solvent is provided in an amount suitable for forming the precipitate containing the component to be recovered. The combination of the functional solution comprising the protic ionic liquid according to this disclosure and water as the complementary solvent in a proper volume ratio allows to obtain either of the ABX$_3$ or BX$_2$ as the recovered component. The complementary solvent may alternatively be selected from other solvents, as long as they will not cause dissolution of the recovered component.

In yet another aspect of the present invention, there is provided use of the protic ionic liquid and the complementary solvent in perovskite recycling process. The use of the protic ionic liquid and the complementary solvent according to the present disclosure enables efficient component recovery, wherein the component is of high purity, wherein the presence of toxic solvents is reduced or eliminated and wherein the component recovery process is carried out at a temperature not higher than 80°C, such as close to or equal to a room temperature.

In another aspect of the present invention, there is provided a method for producing a perovskite material, wherein the perovskite material comprises the component obtained according to the disclosed method. The recovered component may have as good purity as components available commercially (obtained by other methods), therefore it is of particular use for producing perovskite materials of a desired high purity.

BRIEF DESCRIPTION OF DRAWINGS

Aspects and features of the present invention will become apparent by describing, in detail, exemplary embodiments of the present invention with reference to the attached drawings, in which:

Fig. 1 presents a block diagram of the method for recovering a component from a perovskite structure according to an embodiment of the present disclosure;
Fig. 2 presents a block diagram of the method for recovering a component from a perovskite structure according to an embodiment of the present disclosure;
Fig. 3 presents a block diagram of the method for recovering a component from a perovskite structure being a photovoltaic device according to an embodiment of the present disclosure;
Fig. 4 presents a block diagram of the method for recovering a component from a perovskite structure being a photovoltaic device according to an embodiment of the present disclosure;
Fig. 5 presents an X-ray diffractogram of PbI$_2$, which PbI$_2$ being the component recovered according to an embodiment of the present disclosure;

Fig. 6 presents an X-ray diffractogram of MAPbI$_3$, which MAPbI$_3$ being the component recovered according to an embodiment of the present disclosure;

Fig. 7 presents a picture of PbI$_2$ recovered according to an embodiment of the present disclosure;

Fig. 8 presents a picture of PbI$_2$ recovered according to an embodiment of the present disclosure dissolved in DMF;

DETAILED DESCRIPTION OF EMBODIMENTS

Reference will now be made to embodiments, examples of which are illustrated in the accompanying drawings. Aspects and features of the invention will be described with reference to the accompanying drawings. In the drawings, like reference numerals denote like elements. The present invention, however, may be embodied in various different forms and should not be construed as being limited only to the illustrated embodiments. Rather, the presented embodiments are provided as example so that this disclosure will be thorough and complete, and will fully convey the aspects and features of the present invention to those skilled in the art. It shall be understood that not all of the features shown in the embodiment are essential and the scope of the protection is defined not by means of literally shown embodiment, but by the features provided in the claims.

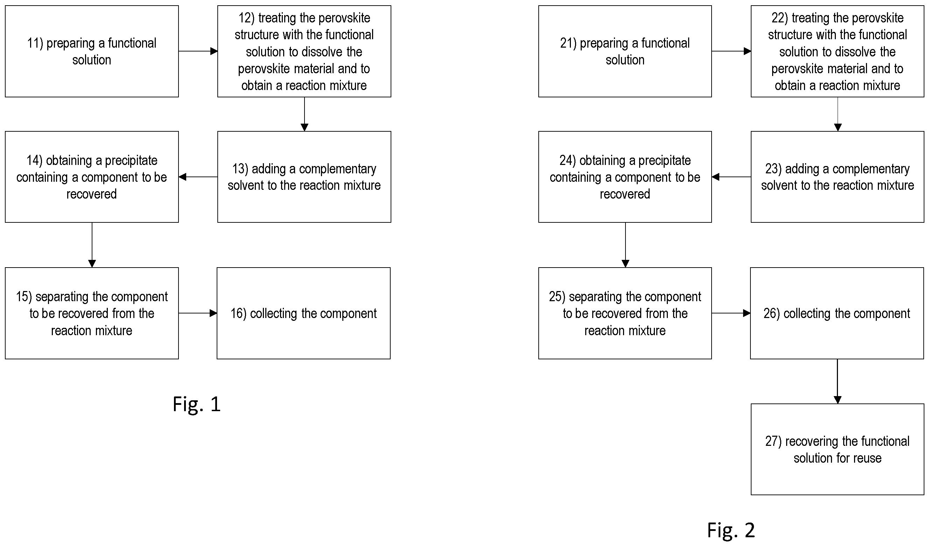

Fig. 1 presents a block diagram of the method for recovering the component from the perovskite structure according to an embodiment of the present disclosure. Step 11 comprises forming the functional solution. The functional solution comprises the protic ionic liquid. Preferably the functional solution comprises a single protic ionic liquid. The functional solution may alternatively comprise more than one protic ionic liquids. Preferably the protic ionic liquid is in a liquid form at room temperature. The protic ionic liquid is selected, so as to be able to effectively dissolve the perovskite material. Step 12 comprises treating the perovskite structure with the functional solution to dissolve the perovskite material and to obtain a reaction mixture. The perovskite structure is a structure that comprises the perovskite material. The amount of the perovskite material within the perovskite structure is not particularly limited. Preferably, the perovskite structure is in form of a pellet comprising the perovskite material, in form of a powder comprising the perovskite material, in form of a layer comprising the perovskite material, which layer forms part of an optoelectronic device, such as a photovoltaic device, or the like. The perovskite structure according to this embodiment is in the form suitable for applying the functional solution on it and dissolving the perovskite material contained therein. Preferably the functional solution is applied on the perovskite structure by means of dripping or immersing. The perovskite structure may be immersed in the functional solution or the functional solution may be applied directly on the perovskite structure. Step 12 that involves treating the perovskite structure with the functional solution is not particularly limited, as long as it allows to dissolve the perovskite material contained in the perovskite structure and to obtain the reaction mixture containing the dissolved perovskite material and the functional solution. Alternative application methods are spraying, spin coating, wiping and/or similar. Step 13 comprises adding the complementary solvent to the reaction mixture obtained in step 12. The complementary solvent is added to the reaction mixture by means of dripping, pouring, pipetting, syringe addition and/or the like. The complementary solvent may be added to the reaction mixture by automated dispensers or any other automated methods of adding one solution to another. Step 14 comprises obtaining the precipitate containing the component to be recovered. After adding the complementary solvent according to step 13, the precipitate starts to form. Depending on the amount of the complementary solvent added to the reaction mixture, either of the components selected from ABX$_3$ and BX$_2$ is obtained. Step 15 comprises separating the component to be recovered from the reaction mixture, which may be carried out by any means selected from: filtration, centrifugation, decantation, sedimentation, washing, dialysis and the like. The separated component may additionally be dried. Preferably, the recovered component is in a powdered form. The recovered component is suitable to be reused, since it is of high purity, which at least limits, or even does not impose, a necessity for further purification steps to be carried out. Step 16 comprises collecting the component, which may be done by any means known in the art.

Fig. 2 presents a block diagram of the method for recovering the component from the perovskite structure according to an embodiment of the present disclosure. The embodiment presented on Fig. 2 contains the steps 21-26, which correspond to the steps 11-16 of the embodiment presented on Fig. 1. Additionally, the embodiment presented on Fig. 2 comprises step 27 that involves recovering the functional solution for reuse. Preferably, step 27 that involves recovering the functional solution for reuse comprises extracting or reducing the amount of residues contained in the functional solution after step 26 that involves collecting the component. The functional solution may contain residues introduced in any of the preceding method steps. In such case, preferably, the functional solution is cleaned from said residues and step 27 that involves recovering the functional solution comprises extracting the residues and removing them from the functional solution or at least reducing their amount in the functional solution. Such removal step is selected from any of: filtration, centrifugation, distillation, residue adsorption, evaporation and the like. The residues introduced to the functional solution may be the complementary solvent, which is completely removed, or removed to a large extent from the functional solution in step 27.

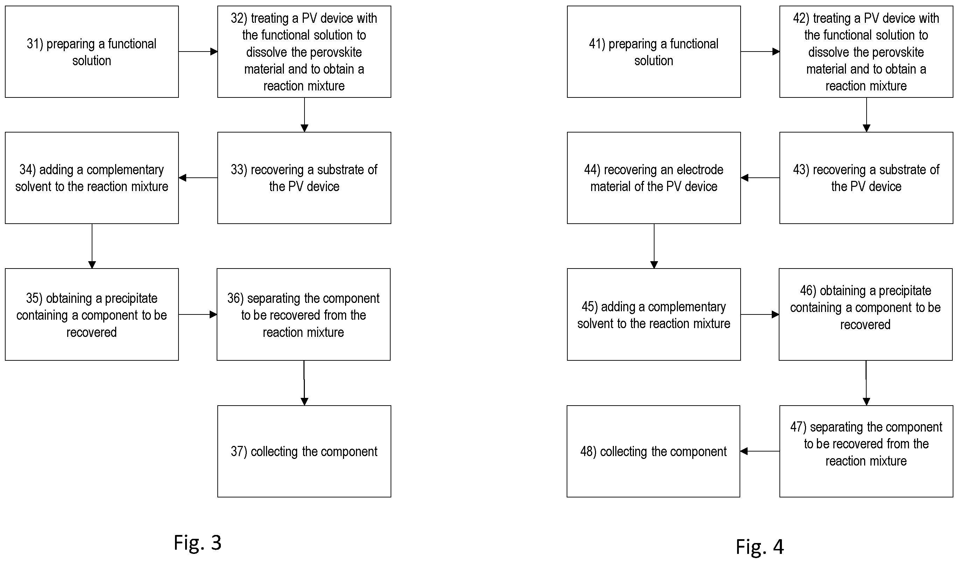

Fig. 3 presents a block diagram of the method for recovering the component from the perovskite structure according to an embodiment of the present disclosure, where the perovskite structure is the optoelectronic device, such as the photovoltaic device. Step 31 comprises forming the functional solution. This step 31 corresponds to the steps 11 and 21 of the embodiments presented on Figs. 1-2.

The perovskite structure according to this embodiment is preferably the photovoltaic device. The photovoltaic device according to this embodiment comprises a layer of the perovskite material and a substrate. The substrate may comprise a transparent electrode. The substrate may also comprise a charge transporting material, such as electron transporting material or hole transporting material. The photovoltaic device may as well comprise additional elements typically present in photovoltaic devices, such as an opposite charge transporting layer, passivation layers, a counter electrode, encapsulation systems, and the like. Step 32 comprises treating the perovskite structure with the functional solution to dissolve the perovskite material and to obtain the reaction mixture. If the photovoltaic device comprises any of the abovementioned additional elements, such as, but not limited to the counter electrode, the opposite charge transporting layer, the passivation layers and/or the encapsulation system or any other elements preventing access to the layer of the perovskite material by the functional solution, preferably they are detached from the rest of the photovoltaic device before step 32 is applied. The counter electrode, the opposite charge transporting layer, the passivation layer(s) and/or the encapsulation system may be detached from the rest of the photovoltaic device by any of the known mechanical, thermal, chemical or ultrasonic methods. Alternatively, any of the abovementioned elements may remain in the photovoltaic device before step 32 is applied. In such a case, they need to be removed from the reaction mixture by any known means, such as any of the known mechanical, chemical, thermal or ultrasonic methods.

Step 32 that involves treating the photovoltaic device with the functional solution is carried out by immersing spraying, spin coating, wiping, pouring and any other suitable means. In step 32, the functional solution dissolves the perovskite material. Even small amount of the functional solution enables rapid dissolution of the perovskite material. The embodiment presented on Fig. 3 comprises step 33 that involves recovering the substrate from the photovoltaic device, so that the substrate is suitable to be reused to produce a new photovoltaic device or in any other application. Preferably, the substrate comprises the transparent electrode. Preferably, the substrate additionally comprises the charge transporting layer, such as the electron transporting layer or the hole transporting layer. The transparent electrode and the charge transporting layer may form part of the recovered substrate. In case any of the transparent electrode or the charge transporting material is soluble in the functional solution, preferably they are removed from the reaction mixture by any means mentioned above.

Step 33 comprises separating the substrate from the reaction mixture comprising dissolved materials and cleaning the substrate, so that it does not contain or contain less amount of unwanted residues. The cleaning step may be done by dipping the substrate in deionized water. It may also be done by any generally known cleaning methods, as long as the recovered substrate and/or any elements forming part of the recovered substrate are not damaged.

Steps 34-37 of the embodiment presented on Fig. 3 correspond to the steps 13-16 and 23-26 of the embodiments presented on Fig. 1 and Fig. 2. The steps 34-37 enable effective collection of the recovered component, which recovered component is suitable to be reused, since it is of high purity, which at least limits, or even does not impose, a necessity for further purification steps to be carried out. This embodiment may additionally comprise the step corresponding to step 27 that involves recovering the functional solution for reuse, as it was described in the embodiment as shown on Fig. 2. The embodiment presented on Fig. 3 allows to efficiently recover the component as well as the substrate from the perovskite structure in form of the photovoltaic device. Recovering the substrate from the photovoltaic device provides a great environmental advantage, since it reduces the waste volume and allows to reuse the substrate in subsequent applications.

Fig. 4 presents a block diagram of the method for recovering the component from the perovskite structure according to an embodiment of the present disclosure, where the perovskite structure is the optoelectronic device, such as the photovoltaic device. Preferably, the perovskite structure according to this embodiment is the photovoltaic device, such as the photovoltaic device of the embodiment presented with regards to Fig. 3 above. The photovoltaic device according to this embodiment comprises a layer of the perovskite material, a substrate and a counter electrode. The substrate may comprise a transparent electrode. The substrate may also comprise a charge transporting material, such as electron transporting material or hole transporting material. Similarly to the embodiment presented on Fig. 3, the photovoltaic device may as well comprise additional elements typically present in photovoltaic devices, such as an opposite charge transporting layer, passivation layers, encapsulation systems, and the like. The embodiment presented on Fig. 4 contains the steps 41-43, which correspond to the steps 31-33 of the embodiment presented on Fig. 3.

The embodiment presented on Fig. 4 comprises the additional step 44 that involves recovering the counter electrode material of the photovoltaic device. Recovery of the electrode material provides economic benefit, since materials used as electrodes, such as gold or silver are typically expensive. It also allows to conserve the resources and reduce waste. Recovering and reusing electrode materials may reduce the total manufacturing cost of the new photovoltaic devices, which is beneficial for process sustainability.

Step 44 that involves recovering the electrode material is performed before or after step 43 that involves recovering the substrate of the photovoltaic device. Preferably, step 44 is performed after step 42 that involves obtaining the reaction mixture, in which the perovskite material dissolves and the substrate and the counter electrode get detached. The counter electrode migrates into the reaction mixture, such as silver or gold. Step 44 comprises filtering the counter electrode material from the reaction mixture. The filtering may be done by any filtration means known in the art, such as using a paper filter or any other suitable means.

Alternatively, the counter electrode may as well be removed before step 42 that involves treating the photovoltaic device with the functional solution, in which step the perovskite material dissolves. In such case the counter electrode may be removed by any suitable means, such as mechanical or thermal methods, including mechanical scraping, peeling or thermal decomposition, provided that the selected means do not damage or negatively affect the rest of the photovoltaic device, before the next steps of the disclosed method are applied.

Additionally, the embodiment presented on Fig. 4 contains the steps 45-48, which correspond to the steps 34-37 of the embodiment presented on Fig. 3. This embodiment may additionally comprise the step corresponding to step 27 that involves recovering the functional solution, as it was described in the embodiment as shown on Fig. 2. The embodiment presented on Fig. 4 allows to efficiently recover the component of high purity, as well as the substrate and the counter electrode from the perovskite structure in form of the photovoltaic device.

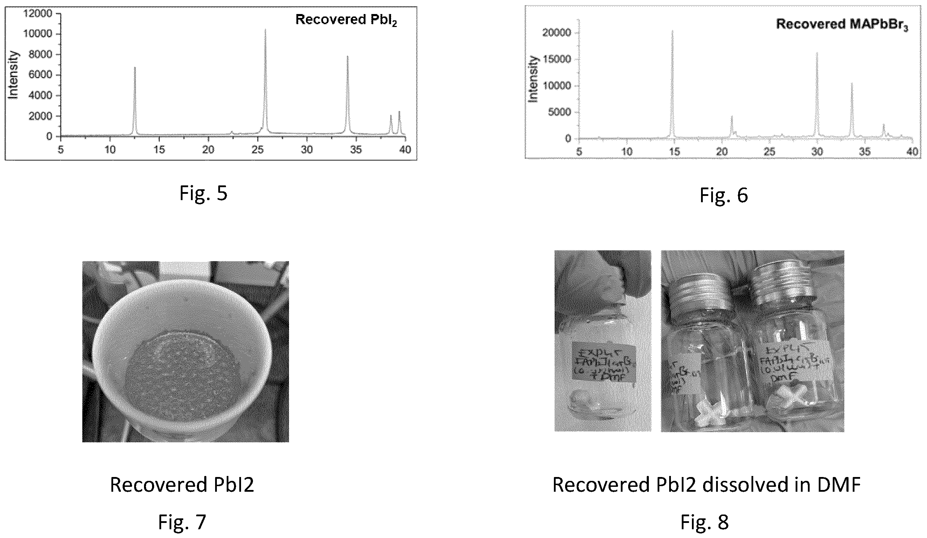

Fig. 5 and Fig. 6 present an X-ray diffractograms of $PbI_2$ and $MAPbI_3$ recovered according to an embodiment of the present disclosure. Presented X-ray diffractograms are comparable with standard reference diffractograms of $PbI_2$ and $MAPbI_3$ respectively, due to matching peak positions and peak intensities, which serve as material identification with a similar or matching crystal structure and absence of significant amounts of impurities, or absence of impurities at all. The method according to the present disclosure enables to recover the component shown on Figs. 5 and 6 for either of the embodiments disclosed on any of the Figs. 1-4.

Fig. 7 presents a picture of $PbI_2$ recovered according to an embodiment of the present disclosure. The $PbI_2$ being the component recovered according to the presented method shown on Fig. 7 is a bright yellow powder, which is a typical appearance of the standard $PbI_2$ powder, which proves that the recovered component is a high quality and high purity $PbI_2$.

Fig. 8 presents a picture of $PbI_2$ recovered according to an embodiment of the present disclosure after dissolution in *N,N*-Dimethylformamide (DMF). The presented picture shows a clear, yellowish solution, which indicates full solubility of the recovered component in DMF. Full solubility and absence of undissolved residues supports the fact that the disclosed method enables recovering the component of high purity with little or no impurities.

### Example 1 - recovery of lead iodide from $ABX_3$ perovskite material

To glass vial, 159 mg of methylammonium iodide and 461 mg of lead(II) iodide were added. The powders were dissolved in methylammonium propionate with vigorous stirring overnight. Then 50 $\mu$l of deionized water was added to the reaction mixture, which immediately caused the perovskite to precipitate out of the solution. Water was continuous added until no more precipitate appeared. The shiny yellow powder appeared upon adding more water and it was collected and dried. The material was identified by powder X-Ray Diffraction (XRD) measurement. Purity was checked by nuclear magnetic resonance (NMR) measurements. The absence of inorganic by-products and impurities was confirmed by a solubility test. For this test, a 1.0M solution in DMF was prepared. The recovered $PbI_2$ dissolved immediately, giving a clear solution.

### Example 2 - recovery of lead iodide from mixed halide $AB(X_1X_2)_3$ perovskite material

To glass vial, 125.0 mg of formamidinium bromide and 449.2 mg of lead(II) iodide and 9.5 mg of lead(II) bromide were added. Th powders were dissolved in ethylammonium acetate with vigorous stirring overnight. Then 50 ml of deionized water was added to the reaction mixture, which immediately caused the perovskite to precipitate out of the solution. Water was continuously added until no more precipitate appeared. The shiny yellow powder appeared upon adding more water and it was collected and dried. The material was identified by powder X-Ray Diffraction (XRD) measurement. Purity was checked by nuclear magnetic resonance (NMR) measurements. The absence of inorganic by-products and impurities was confirmed by a solubility test. For this test, a 1.0M solution in DMF was prepared. The recovered material dissolved immediately, giving a clear solution. $PbI_2$ was identified from XRD measurement. Additionally, the purity of the $PbI_2$ correlated to halogen species in the halide was confirmed by XPS measurement, yielding 98%-99% of iodide and 1%-2% of bromide.

### Example 3 - recovery of lead iodide from mixed A-site cation $A_1A_2BX_3$ perovskite material

To glass vial was added to 48 mg of methylammonioum iodide, 121 mg of formamidinium iodide and 461 mg of lead(II) iodide. Powder was dissolved in hexylammonium propionate with vigorous stirring overnight. Then 50 $\mu$l of deionized water was added to the reaction mixture, which immediately caused the perovskite to precipitate out of the solution. Water was continuous added until no more precipitate appeared. The shiny yellow powder appeared upon adding more water and it was collected and dried. The material was identified by powder X-Ray Diffraction (XRD) measurement. Purity was checked by nuclear magnetic resonance (NMR) measurements. The absence of inorganic by-products and impurities was confirmed by a solubility test. For this test, a 1.0M solution in DMF was prepared. The recovered $PbI_2$ dissolved immediately, giving a clear solution.

### Example 4 - recovery of $ABX_3$ perovskite component

To a glass vial, 112 mg of methylammonium bromide and 461 mg of lead(II) bromide were added. The powder was dissolved in the butylammonium acetate with vigorous stirring overnight. Then, 50 $\mu$L of deionized water was added to the reaction mixture, causing the mixture to precipitate. Water was continuous added until no more precipitate appeared. It was then stirred overnight. An intense orange powder was collected and dried. The material was identified by powder X-ray diffraction (XRD) measurements. The purity was confirmed by NMR measurements.

### Example 5 - recovery of lead iodide and a transparent substrate from a the photovoltaic device

The encapsulation structure and the counter electrode were mechanically removed from the photovoltaic device. The photovoltaic device was immersed in methylammonium acetate at room temperature, causing the perovskite material to gradually dissolve and the substrate of the photovoltaic device to turn colorless and transparent. The reaction mixture was obtained, which became colorless or yellow-straw. The reaction mixture contained dissolved perovskite. At this step, the reaction mixture and the substrate were separated. The substrate was soaked in a weak acid solution and cleaned with water, acetone, and isopropanol. Lead iodide was then precipitated by adding water to the reaction mixture. The recovered lead iodide showed no inorganic by-products or impurities when 1.0 M solution of $PbI_2$ in DMF was prepared and stirred, resulting in a clear solution.

### Claims

1.  A method for recovering at least one component from a perovskite-containing structure comprising a perovskite material ABX3, the method comprising the steps of:

    (a) preparing a functional solution,
    (b) treating the perovskite-containing structure with the functional solution to dissolve the perovskite material and to obtain a reaction mixture,
    (c) adding a complementary solvent to the reaction mixture,
    (d) obtaining a precipitate containing the component to be recovered,
    (e) separating the component to be recovered from the reaction mixture,
    (f) collecting the component,

    **characterized in that** the functional solution comprises a protic ionic liquid.

2.  The method according to claim 1, wherein each of steps (a)-(f) is carried out at a temperature of less than 80°C.

3.  The method according to any of the preceding claims, wherein the method further comprises step (g) that involves recovering the functional solution for reuse, wherein step (g) comprises extracting the complementary solvent from the functional solution.

4.  The method according to any of the preceding claims, wherein the complementary solvent is added to the reaction mixture in a volume ratio of the complementary solvent to the functional solution between 0.1: 1 and 40: 1.

5.  The method according to any of the preceding claims, wherein the functional solution comprises the protic ionic liquid of a general formula (I):

$$\mathbf{M^+N^-}$$

**Formula I**

wherein:

   $M^+$ represents a cation selected from the group of $C_1$-$C_{20}$ alkyl ammonium cations

N⁻ represents at least one carboxylate anion, preferably an anion selected from the group of $C_1$-$C_{20}$ carboxylate anions.

6. The method according to any of the preceding claims, wherein the functional solution comprises the protic ionic liquid selected from the group consisting of MAF, MAAc, MAP, MABur, MAVal, $MAC_6$, EAF, EAAc, EAP, EABur, EAVal, $EAC_6$, PrAF, PrAc, PrAP, PrBur, PrVal, $PrC_6$, BuF, BuAc, BuP, BuBur, BuVal, $BuC_6$, PenF, PenAc, PenP, PenBur, PenVal, $PenC_6$, HexF, HexAc, HexP, HexBur, HexVal, $HexC_6$.

7. The method according to any of the preceding claims, wherein the complementary solvent is selected from the group of water, ethanol, propanol, isopropanol, butanol, $\gamma$-butyrolactone, valerolactone, acetonitrile and ethyl lactate.

8. Use of a protic ionic liquid and a complementary solvent in a perovskite recycling process.

| | |
|---|---|
| 11) preparing a functional solution | 12) treating the perovskite structure with the functional solution to dissolve the perovskite material and to obtain a reaction mixture |
| 14) obtaining a precipitate containing a component to be recovered | 13) adding a complementary solvent to the reaction mixture |
| 15) separating the component to be recovered from the reaction mixture | 16) collecting the component |

Fig. 1

| | |
|---|---|
| 21) preparing a functional solution | 22) treating the perovskite structure with the functional solution to dissolve the perovskite material and to obtain a reaction mixture |
| 24) obtaining a precipitate containing a component to be recovered | 23) adding a complementary solvent to the reaction mixture |
| 25) separating the component to be recovered from the reaction mixture | 26) collecting the component |
| | 27) recovering the functional solution for reuse |

Fig. 2

**Fig. 4**

41) preparing a functional solution → 42) treating a PV device with the functional solution to dissolve the perovskite material and to obtain a reaction mixture → 43) recovering a substrate of the PV device → 44) recovering an electrode material of the PV device → 45) adding a complementary solvent to the reaction mixture → 46) obtaining a precipitate containing a component to be recovered → 47) separating the component to be recovered from the reaction mixture → 48) collecting the component

**Fig. 3**

31) preparing a functional solution → 32) treating a PV device with the functional solution to dissolve the perovskite material and to obtain a reaction mixture → 33) recovering a substrate of the PV device → 34) adding a complementary solvent to the reaction mixture → 35) obtaining a precipitate containing a component to be recovered → 36) separating the component to be recovered from the reaction mixture → 37) collecting the component

Recovered MAPbBr₃

Fig. 6

Recovered PbI2 dissolved in DMF

Fig. 8

Recovered PbI₂

Fig. 5

Recovered PbI2

Fig. 7

Europäisches Patentamt

European Patent Office

Office européen des brevets

# EUROPEAN SEARCH REPORT

**Application Number**

EP 24 46 1588

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2023/304125 A1 (LIU FAN-WEI [TW] ET AL) 28 September 2023 (2023-09-28)<br>* claim 1 to 9 *<br>* example 1 *<br>----- | 1-8 | INV.<br>C22B3/26<br>C01D3/12<br>C01G21/16<br>C22B7/00 |
| Y | WO 2019/138154 A1 (AALTO KORKEAKOULUSAEAETIOE SR [FI]; SOLARONIX S A [CH]) 18 July 2019 (2019-07-18)<br>* claims 1-16 *<br>----- | 1-8 | H10K30/50<br>C22B13/00<br>H10K85/00<br>C22B3/00 |
| Y | US 2024/100580 A1 (WANG RUI [CN] ET AL) 28 March 2024 (2024-03-28)<br>* claims 1-7 *<br>* paragraph [0008] - paragraph [0017] *<br>* paragraph [0029] *<br>----- | 1-8 | |
| Y | CN 111 434 614 A (MICROQUANTA CO LTD) 21 July 2020 (2020-07-21)<br>* claims 1-9 *<br>* examples 1-2 *<br>----- | 1-8 | |
| Y | SENOL ÖZ ET AL: "Protic ionic liquid assisted solution processing of lead halide perovskites with water, alcohols and acetonitrile",<br>NANO ENERGY,<br>vol. 51, 1 September 2018 (2018-09-01), pages 632-638, XP055656874,<br>NL<br>ISSN: 2211-2855, DOI: 10.1016/j.nanoen.2018.07.005<br>* first paragraph;<br>page 633 *<br>* figure S1 *<br>----- | 1-8 | **TECHNICAL FIELDS SEARCHED (IPC)**<br><br>C22B<br>H10K<br>C01G |

-/--

The present search report has been drawn up for all claims

| Place of search | Date of completion of the search | Examiner |
|---|---|---|
| The Hague | 12 November 2024 | Martinez Miró, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

| | Europäisches Patentamt<br>European Patent Office<br>Office européen des brevets | **EUROPEAN SEARCH REPORT** | **Application Number**<br><br>EP 24 46 1588 |

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | WO 2023/202389 A1 (HANGZHOU MICROQUANTA SEMICONDUCTOR CORPORATION LTD [CN]) 26 October 2023 (2023-10-26) * the whole document * ----- | 1-8 | |
| A | CN 112 593 089 A (UNIV SOUTHERN SCI & TECH) 2 April 2021 (2021-04-02) * the whole document * ----- | 1-8 | |
| A | CN 117 230 315 A (SHENZHEN XIANXIANG PHOTOVOLTAIC TECH CO LTD) 15 December 2023 (2023-12-15) * the whole document * ----- | 1-8 | |

TECHNICAL FIELDS SEARCHED (IPC)

The present search report has been drawn up for all claims

| Place of search | Date of completion of the search | Examiner |
|---|---|---|
| The Hague | 12 November 2024 | Martinez Miró, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.................................................................................................

& : member of the same patent family, corresponding document

EPO FORM 1503 03.82 (P04C01)

EP 4 663 786 A1

## ANNEX TO THE EUROPEAN SEARCH REPORT
## ON EUROPEAN PATENT APPLICATION NO.

EP 24 46 1588

This annex lists the patent family members relating to the patent documents cited in the above-mentioned European search report.
The members are as contained in the European Patent Office EDP file on
The European Patent Office is in no way liable for these particulars which are merely given for the purpose of information.

12-11-2024

| Patent document cited in search report | | Publication date | Patent family member(s) | | Publication date |
|---|---|---|---|---|---|
| US 2023304125 | A1 | 28-09-2023 | TW | 202339320 A | 01-10-2023 |
| | | | US | 2023304125 A1 | 28-09-2023 |
| WO 2019138154 | A1 | 18-07-2019 | NONE | | |
| US 2024100580 | A1 | 28-03-2024 | CN | 114871254 A | 09-08-2022 |
| | | | US | 2024100580 A1 | 28-03-2024 |
| | | | WO | 2023193688 A1 | 12-10-2023 |
| CN 111434614 | A | 21-07-2020 | NONE | | |
| WO 2023202389 | A1 | 26-10-2023 | CN | 116997223 A | 03-11-2023 |
| | | | WO | 2023202389 A1 | 26-10-2023 |
| CN 112593089 | A | 02-04-2021 | NONE | | |
| CN 117230315 | A | 15-12-2023 | NONE | | |

EPO FORM P0459

For more details about this annex : see Official Journal of the European Patent Office, No. 12/82

**REFERENCES CITED IN THE DESCRIPTION**

**Patent documents cited in the description**

- US 18522428 B

- FI 2018050983 W